# EUROPÄISCHE PATENTSCHRIFT

(11) **EP 0 530 236 B1**
(45) Veröffentlichungstag und Bekanntmachung des Hinweises auf die Patenterteilung: **08.03.1995**
(21) Anmeldenummer: 91909258.5
(22) Anmeldetag: 09.05.1991
(51) Int. Cl.: H01J 37/32, G01B 11/06

(54) **VERFAHREN ZUR ÜBERWACHUNG UND STEUERUNG EINES ÄTZVORGANGS UND VORRICHTUNG HIERFÜR**
PROCESS AND DEVICE FOR MONITORING AND CONTROLLING ETCHING OPERATIONS
PROCEDE ET DISPOSITIF DE SURVEILLANCE ET DE COMMANDE D'OPERATIONS DE GRAVURE

(30) Priorität: 19.05.1990 DE 4016211
(43) Veröffentlichungstag der Anmeldung: 10.03.1993
(73) Patentinhaber: CONVAC GMBH, D-75446 Wiernsheim (DE); INTERNATIONAL BUSINESS MACHINES CORPORATION, Armonk, NY 10504 (US)
(72) Erfinder: BUND, Joachim, D-7147 Eberdingen (DE); GABRIEL, Silke, D-7000 Stuttgart 40 (DE); MEINHOLD, Henner, D-7250 Leonberg (DE); REISCHMANN, Robert, D-7032 Sindelfingen (DE)
(74) Vertreter: Hosenthien, Heinz
(86) Internationale Anmeldenummer: EP9100870
(87) Internationale Veröffentlichungsnummer: WO9118412

(56) Entgegenhaltungen:
- EP-A- 151 947
- US-A- 4 767 495
- PATENT ABSTRACTS OF JAPAN, vol. 7, No. 214 (E-199), 21 September 1983 ; & JP-A-58 107 634
- PATENT ABSTRACTS OF JAPAN, vol. 5, No. 205 (E-88)(877), 25 December 1981 ; & JP-A-56 125 841
- PATENT ABSTRACTS OF JAPAN, vol. 10, No. 256 (P-493), 2 September 1986 ; & JP-A-61 83 904
- PATENT ABSTRACTS OF JAPAN, vol. 10, No. 186 (E-146), 28 June 1986 ; & JP-A-61 34 943
- PATENT ABSTRACTS OF JAPAN, vol. 4, No. 7 (C-70), 19 January 1980 ; & JP-A-54 142 144
- PROCEEDINGS 1987 IEEE INTERNATIONAL ELECTRONIC MANUFACTURING TECHNOLOGY SYMPOSIUM, 14 October 1987, Anaheim, CA, US, pp. 61-66 ; CHEN et al.: "A color vision measurement system - film thickness determination"

## Beschreibung

Die Erfindung betrifft ein Verfahren zur Überwachung und Steuerung eines Ätzvorgangs, bei dem eine oder mehrere auf einem Substrat aufgebrachte Licht wellenselektiv reflektierende Schichten mit vorgegebener Ätzzeit abgetragen werden, wobei während dem Ätzvorgang ein Lichtstrahl mit weißem Licht auf die abzutragende Schicht gerichtet, der reflektierende Lichtstrahl analysiert und beim Eintreten eines vorgegebenen Ergebnisses der Ätzvorgang beendet wird.

In der Technologie für Halbleiter-, Keramik-, Glaskeramik-Substrate und gedruckte Schaltungen gibt es Anordnungen, bei welchen auf einem Substrat ggf. mehrere Schichten unterschiedlicher Materialzusammensetzung aufgebracht sind. Im Verlauf des Herstellungsprozesses müssen diese Schichten, nachdem sie mit Fotolack beschichtet und diese Lackschicht entwickelt wurde, selektiv wieder weggeätzt werden. Der Ätzvorgang erfolgt meist in bewegten bzw. geprühten Ätzmedien, um eine gleichmäßige Ätzung zu erzielen. Die Ätzgeschwindigkeit ist hierbei eine Funktion des zu ätzenden Materials, des Ätzmediums, der Temperatur, sowie der Ätzmediumverunreinigung, die im Laufe meherer Ätzvorgänge erfolgt. Dabei ist wichtig festzustellen, wann der Ätzprozeß beendet ist, d.h. den Zeitpunkt zu bestimmen, bei dem das abzuätzende Material gerade entfernt ist.

Das eingangs beschriebene Verfahren ist bspw. aus den Patent Abstracts of Japan, Vol. 007, No. 214 (E-199), 21 September 1983 & JP-A-58 107 634 (TOUHOKU KINOKU KOGYO KK) 27. Juni 1983 bekannt. Danach wird über einen Wellenlängenanalysator die Wellenlänge der Lichtquelle mit der Wellenlänge des reflektierten Lichtstrahls verglichen und bei gleicher Wellenlänge der Bearbeitungsprozeß beendet. Nun kann aber bei unterschiedlichen Materailien die Wellenlänge des auftreffenden Lichts unterschiedlich sein zur Wellenlänge des reflektierten Lichts, so daß hier der Bearbeitungsprozeß nicht beendet wird und so Bearbeitungsfehler auftreten können.

Aus den Patent Abstracts of Japan, Vol.10, No.256 (P-493), 2. September 1986 & JP-A-61 83 904 (DAINCHI NIPPON CABLES LTD), 28. April 1986 ist eine weitere Vorrichtung mit einem Projektionslichtleiter, einem Empfangslichtleiter, einem Farberkennungsgerät usw. bekannt, bei der der zeitliche Kurvenverlauf der Intensität einer Wellenlänge mit einem Detektor gemessen und zur Auslösung der Beendigung des Ätzvorgangs verwendet wird. Eine Spezifizierung zur Berücksichtigung besonderer physikalischer Verhältnisse, durch die die Lichtreflexion beeinfluß wird, ist dort nicht beschrieben.

Aus den Patent Abstracts of Japan, Vol.4, No.7 (C-70) 19.Januar 1980 & JP-A-54 142 144 (Nichiden Varian KK) 6. November 1978 ist es bekannt, zwei Signale zu vergleichen und zur Steuerung eines Geräts zu verwenden.

Aus der EP-A-151 947 ist es weiter bekannt, den Wendepunkt einer Intensitätskurve zur Steuerung in einem "Plasma-etching"-Verfahren einzusetzen.

In Vermeidung der geschilderten Nachteile liegt der vorliegenden Erfindung die Aufgabe zugrunde, ein Verfahren anzugeben, bei dem der Abschluß des Ätzvorgangs während des Ätzens einfach automatisch auch bei den unterschiedlichen Schichtmaterialien gefunden werden kann.

Zur Lösung dieser Aufgabe sieht die Erfindung vor, daß der reflektierte Lichtstrahl in spektrale Komponenten zerlegt und die Intensität einer oder mehrerer Komponenten erfaßt und ausgewertet und bei einer charakteristischen Änderung des zeitlichen Kurvenverlaufs der Intensität mindestens einer spektralen Komponente der Ätzvorgang beendet wird (Endpunkt-Erfassung).

Bei dem hier beschriebenen Verfahren macht man sich die strahlungsphysikalische (lichttechnische) Tatsache zunutze, daß Oberflächen von Schichten unterschiedlicher Stoffe unterschiedliche Reflexionsgrade besitzen, wodurch einfallendes weißes Licht unterschiedlich stark und wellenlängen-selektiv reflektiert wird; d.h., wird eine Oberfläche mit weißem Licht bestrahlt, besitzt das reflektierte Licht aufgrund des material- und oberflächenspezifischen (absoluten) Reflexionsgrades als auch aufgrund des lichtwellenabhängigen spektralen sowie integralen Reflexiongrades jeweils bestimmte, die Materialschicht kennzeichnende Eigenschaften. So ist die jeweilige Komponentenintensität des mittels Filtern spektral zerlegten reflektierten Lichts materialabhängig festgelegt. Beim Übergang von einer Schicht auf eine andere tritt hierdurch während dem Abtragungsvorgang eine charakeristische Änderung im zeitlichen Kurvenverlauf der Farbkomponentenintensitäten auf, die zwar abhängig von den unterschiedlichen Reflexionscharakteristika des Schicht-Substrats-Materialsystems, aber unabhängig von anderen Ätzparameter ist.

Diese Intensitätsänderungen können bspw. anhand eines handelsüblichen Farberkennungsgeräts festgestellt und mittels einer entsprechend programmierten Datenverarbeitungsanlage DVA ausgewertet werden.

Da sich während dem tatsächlichen Ätzvorgang je nach Materialkombination unterschiedliche Kurvenverläufe der Farbkomponentenintensitäten über der Zeit ergeben, aber die charakteristische Änderung bei vollständiger Abtragung der abzuätzenden Schicht abhängig vom Schicht-Substratsystem immer die gleiche ist, kann diese zuvor experimentell bestimmt und als Referenzgröße für die Auswertung der jeweiligen Kurvenverläufe festgelegt werden.

Hierdurch wird der Ätzvorgang unabhängig von der tatsächlichen Ätzgeschwindigkeit, der Dicke der abzuätzenden Schicht sowie des Ätzmediums also erst nach erfolgtem vollständigen Entfernen der abzutragenden Schicht beendet.

Die charakterisitische Änderung in der Komponentenintensitätskurve kann je nach Schicht-Substratsystem dabei ein Hoch- bzw. Tiefpunkt oder ein Wendepunkt sein; eine andere charakteristische Änderung kann durch den Überkreuzungspunkt zweier Komponenten-Intensitätskurven gegeben sein. Die charakteristische Änderung wird als sog. Triggerpunkt bezeichnet.

Zweckmäßigerweise wird ein Hoch- bzw. Tiefpunkt als charakteristische Änderung der Komponentenintensitätskurve bei Ätzvorgängen festgelegt werden, bei welchen die abzutragende Schicht und die Substratschicht stark abweichende Reflexionsgrade aufweisen, bspw. beim Abtragen einer Metallschicht von einer Keramik- Substrat-Schicht, Chrom von einer Silizium-Substrat-Schicht oder Kupfer von einer Aluminium-Substrat-Schicht.

Weisen die abzutragende Schicht und die darunterliegende Substratschicht ähnliche Reflexionsgrade auf, so wird vorteilhafterweise ein Wendepunkt in einer der Lichtkomponentenintensitäten festgelegt werden, da ausgesprochene Hoch- bzw. Tiefpunkte im Kurvenverlauf nicht zu erwarten sind.

Vorteilhaft kann auch die Festlegung des Überkreuzungspunktes zweier Komponentenintensitäten als charakterisitische Änderung festgelegt werden.

In besonders vorteilhafter weiterer Ausgestaltung des Verfahrens ist ferner vorgesehen, daß der Ätzvorgang zu einem späteren Zeitpunkt tₑ abgebrochen werden kann als dem der charakteristischen Änderung (Triggerpunkt) korrespondierenden Triggerzeitpunkt tₒ, wodurch sich geringfügige Intensitätsschwankungen, welche sich auch in einer Änderung des zu der charakteristischen Änderung gehörenden Triggerzeitpunkts tₒ äußern, kompensieren lassen.

Eine weitere vorteilhafte Ausgestaltung des Verfahrens sieht vor, daß die Zeit zwischen Anfang und Ende des Ätzvorgangs erfaßt und beim Überschreiten einer vorgegebenen Abweichung von einem vorbestimmten Sollwert eine Fehlermeldung erfolgen kann. Als Sollzeit kann zweckmäßigerweise die experimentell ermittelte Ätzzeit festgelegt werden, bei der eine vollständige Abtragung des Schichtmaterials bei vorgegebener Soll-Dicke unter optimalen Abtragungsparametern wie Ätzmittelkonzentration und Temperatur unter wirtschaftlichen Gesichtspunkten stattgefunden hat und die einer bestimmten charakteristischen Änderung im Intensitätskurvenverlauf des optimalen Ätzprozesses als Triggerzeitpunkt tₒ zuordenbar ist; Es kann aber auch der zuvor erwähnte experimentell festgelegte spätere Zeitpunkt tₑ als Sollwert verwendet werden. Durch Vergleich der Ist-Ätzzeit mit der Soll-Ätzzeit, können somit Abweichungen während dem Ätzprozess festgestellt werden, insbesondere Abweichungen in der Schichtdicke aufgrund von Herstellungsfehlern, oder insbesondere Konzentrationsänderungen des Ätzmittels, welche aufgrund von Verunreinigungen im Laufe mehrerer Ätzprozesse durch die abgeätzten Stoffe erfolgt. Hierdurch kann vor einem erneuten Ätzvorgang das Ätzmittel entsprechend ausgetauscht und erneuert werden und so ein wirtschaftlich optimierter Ätzvorgang gesichert werden, sowie Korrekturen im Schicht-Auftragungsverfahren im vorangehenden Prozeß zur Dickenoptimierung vorgesehen werden.

Eine geeignete Vorrichtung zur Durchführung des Verfahrens weist eine Weißlicht-Lampe mit anschließendem, ggf. eine Optik aufweisenden Lichtleiter auf, einen weiteren Lichtleiter, an den sich ein handelsübliches Farberkennungsgerät anschließt, in dem das reflektierte Licht ggf. mittels Filter in Spektralfarbkomponenten zerlegbar und die Komponentenintensitäten erfaßt und in Meßsignale transformierbar sind, und eine mit einer Meßsignalerfassung versehene Datenverarbeitungsanlage zur Echtzeit-Auswertung der Meßsignale und ggf. Steuerung der gesamten Ätzvorrichtung.

Eine solche Vorrichtung befindet sich z.B. in einem für das beschriebene Verfahren besonders vorteilhaften Spindelsprühätzgerät. Außer der Vorrichtung zur Durchführung des Verfahrens zur Überwachung und Steuerung des Ätzvorganges in situ mit dem Ätzvorgang enthält dieses Ätzgerät u.a. eine in eine Drehrichtung antreibbare Vorrichtung zur Aufnahme der zu ätzenden Substrate sowie Strahldüsen zum teilflächigen Aufsprühen des Ätzmediums.

Weitere erfindungsgemäße Ausbildungen sind den Unteransprüchen zu entnehmen und werden anhand des nachfolgend beschriebenen Ausführungsbeispiels eines Verfahrens und einer hierfür geeigneten Vorrichtung anhand der beigefügten Zeichnung näher erläutert. Es zeigt:
- Figur 1: ein schematisches Blockschaltbild einer Vorrichtung zur Durchführung des Verfahrens;
- Figur 2: der Kurvenverlauf der Intensität des reflektierten Lichts einer Farbkomponente während dem Ätzvorgang einer abzuätzenden Schicht aufgetragen über die Zeit;
- Figur 3: den Kurvenverlauf zweier Komponentenintensitäten während dem Ätzvorgang einer abzuätzenden Schicht aufgetragen über die Zeit;
- Figur 4: ein Intensitäts-Zeit-Diagramm mit mehreren während dem Ätzen mehrerer identischer Schichten aufgenommenen Kurven.

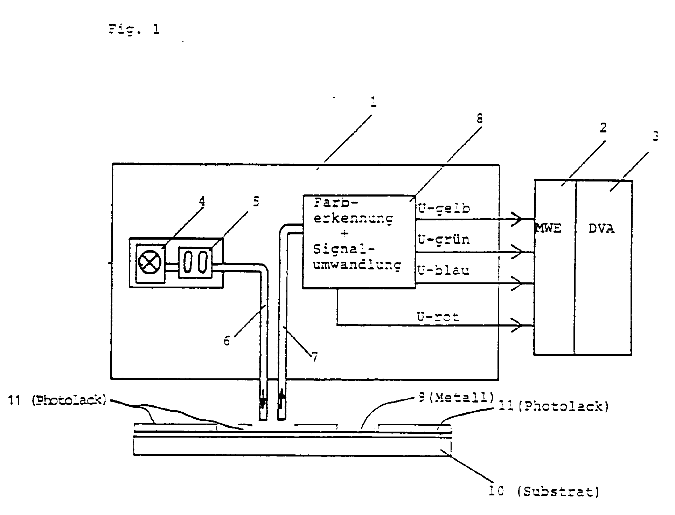

In Figur 1 ist eine Vorrichtung zur Überwachung und Steuerung eines Ätzvorgangs in einem Blockschaltbild schematisch dargestellt, mittels der bspw. im Herstellungsverfahren für gedruckte Schaltungen oder für Erzeugung von metallischen Leiterbahnen auf Siliziumwafern oder auf Keramiksubstraten der Ätzvorgang zur Bildung des Leiterzugbilds nach dem Fotolackverfahren überwacht und gesteuert werden kann. Hierbei ist auf einem Substrat 10 ein Metall als leitende Schicht 9 flächig aufgebracht und teilweise mittels eines Fotolacks 11 entsprechend eines auszubildenden Leiterbildes abgedeckt. Zur Erzeugung des Leiterbilds wird der nicht abgedeckte Bereich der Schicht 9 in einem Ätzvorgang in bewegtem Ätzmedium (Chromsäure, Kupferchlorid, alkalische Ätzmedien) selektiv abgetragen. Zur Überwachung und Bestimmung des Punktes, an dem die wegzuätzende Schicht vollständig abgetragen ist, d.h. zur sog. Endpunkterfassung oder Endpointdetection dient eine Vorrichtung 1 bestehend aus einer Weißlicht-Lampe 4, die über eine Optik 5 und einen ersten Lichtleiter 6 die Oberfläche der abzuätzenden Schicht 9 beleuchtet. Das reflektierte Licht wird über einen zweiten Lichtleiter 7 in ein handelsübliches Farberkennungsgerät 8 geleitet, wo es z.T. über Filter in die drei Spektralkomponenten rot, grün und blau zerlegt und die Gesamtintensität des reflektierten Lichts sowie die Komponentenintensitäten erfaßt werden. Diese werden in Meßsignale, bspw. in elektrische Spannungen Uges, U-rot, U-grün, U-blau umgeformt und an eine mit einer Meßsignalerfassung 2 versehene Datenverarbeitungsanlage 3 zur Echtzeit-Meßwertverarbeitung und ggf. Aufzeichung für eine statistische Prozeßkontrolle zugeführt.

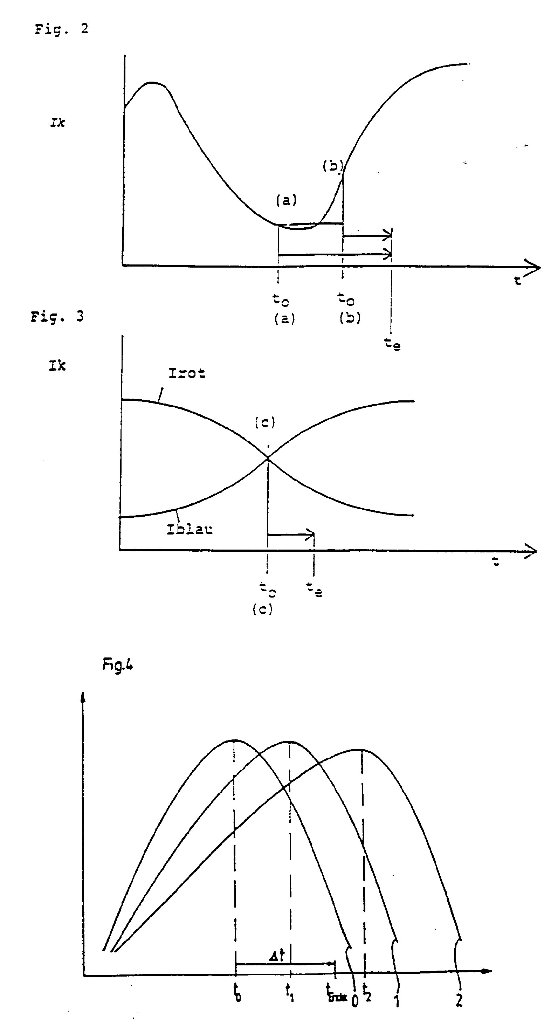

Je nach Material des Substrats 10 sowie der abzuätzenden Schicht 9 und der Schichtdicke ergeben sich während dem Wegätzen unterschiedliche Kurvenverläufe für die Komponentenintensität des reflektierten Lichts. Während dem Abtragvorgang ändert sich der Reflektionsgrad ausgehend vom Wert für die Schicht 9 in den Wert des darunter liegenden Substrats 10, wodurch eine Intensitätsschwankung des aufgenommenen reflektierten Lichts abhängig der Schicht- und Substratzusammensetzung erfolgt. Diese Änderung kann sich je nach Materialzusammensetzung beim Übergang in unterschiedlichen charakteristischen Änderungen des zeitlichen Intensitätskurvenverlaufs äußern, bspw. in einem Hoch-, Tief- oder Wendepunkt, wie dies bspw. in Figur 2 anhand eines Tiefpunkts (a) und eines Wendepunkts (b) im zeitlichen Intensitätsverlauf einer Farbkomponente bzw. Meßwertspannungsverlaufs wiedergegeben ist. Die vollständige Abtragung der Schicht 9 ist somit je nach Materialzusammensetzung des Schicht-Substrat-Systems entweder im Punkt a oder b feststellbar, so daß eines dieser Punkte experimentell als "Endpunkt", d.h. Endpoint oder Triggerpunkt, bei der Materialabtragung festgelegt wird und der DVA als Referenzgröße dient, bei dessen Erreichen der Ätzvorgang abgebrochen wird. Dem Triggerpunkt ist jeweils ein Triggerzeitpunkt tₒ zugeordnet.

Bei Erfassung und Verarbeitung der Intensitäten von Einzelfarbkomponenten können sich die zeitliche Intensitätskurven, wie dies für Schichten und Substraten mit erkennbar unterschiedlichen Farben in Figur 3 anhand der Komponentenintensitäten der Rotlicht- und Blaulichtkomponenten gezeigt ist verhalten, wobei dann der Triggerpunkt auch durch einen Punkt c festgelegt sein kann, in dem sich die Kurven schneiden. Ein solcher Komponentenintensitätskuvenverlauf ist bspw. für den Abtragungsvorgang einer Kupferschicht von einem Aluminiumsubstrat charakteristisch. Die reflektierte "Rotlicht"-Komponente nimmt bei Abnahme der Cu-Schicht ab, wohingegen die reflektierte "Blaulicht"-Komponente des Aluminiums zunimmt. Der Schnittpunkt beider Kurven bestimmt im wesentlichen den "Endpunkt", d.h. den Punkt, bei dem die Abtragung der Cu-Schicht vollständig abgeschlossen ist.

Wie in den Figuren 2 und 3 gezeigt ist, kann der Abtragvorgang auch etwas später als zu dem mit dem Triggerpunkt korrelierten Triggerzeitpunkt tₒ beendet werden. Dieser spätere Zeitpunkt tₑ kann experimentell durch tₑ = tₒ (1 + x) festgelegt werden, um etwaige Schwankungen im Meßwertverlauf kompensieren zu können, wobei x = tₑ tₒ - 1, wie anhand von Versuchen festgestellt wurde, größer oder kleiner gleich eins sein kann.

Wenn sich z.B. die Dicke der zu ätzenden Schicht oder die Ätzbadkonzentration ändert, verschiebt sich die charakteristische Änderung d.h. der Triggerpunkt und somit die tatsächlich verstrichene Zeit bis zum Erreichen des Punktes an dem der Abtragvorgang beendet ist, d.h. der tatsächliche Triggerzeitpunkt t₁ nach hinten.Dies ist anhand des Diagramms in Fig. 4 für drei verschiedene Intensitätskurven gezeigt. Ausgehend vom Triggerpunkt und hiermit korrelierten Triggerzeitpunkt tₒ unter optimalen Ätzbedingungen verschiebt sich im jeweiligen Kurvenverlauf der Triggerpunkt nach hinten, da die vollständige Wegätzung der Schicht 9 erst zu einem späteren Zeitpunkt t₁ oder t₂ stattfindet, wodurch das tatsächliche Ende t_{ENDE} des Ätzprozesses zu einem späteren Zeitpunkt als der Triggerzeitpunkt tₒ auftritt. Dies kann von der Datenverarbeitungsanlage 3 erfaßt werden. Liegt die gemessene Zeit t₁, t₂ des Triggerpunkts außerhalb eines vorgegebenen Toleranzbereichs t bezüglich dem unter optimalen Prozeßbedingungen als Referenzgröße festgelegten Triggerzeitpunkts t₀, welcher bei optimaler Ätzmittelkonzentration und Soll-Dicke der abzutragenden Schicht festgelegt wurde, erfolgt vor Einleitung des nächten Ätzprozesses eine Fehlermeldung, so daß entweder die Ätzbadkonzentration und -zusammensetzung gemessen wird und eine anschließende Erneuerung vorgenommen wird oder eine Überprüfung der Schichtdicke erfolgt.

Die hier beschriebene Endpunkt-Erfassung ist somit in jeglichem Abtragvorgang einer Schicht von einem Substrat einsetzbar, bei welchen aufgrund der unterschiedlichen lichttechnischen Materialkoeffizienten eine Intensitätsveränderung im reflektrierten Licht bei Übergang von der abzutragenden Schicht auf die darunterliegende Substratschicht erfolgt.

## Patentansprüche

1. Verfahren zur Überwachung und Steuerung eines Ätzvorgangs, bei dem eine oder mehrere auf einem Substrat (10) aufgebrachte Licht wellenselektiv reflektierende Schichten (11) mit vorgegebener Ätzzeit (tₑ) abgetragen werden, wobei während dem Ätzvorgang ein Lichtstrahl (6) mit weißem Licht auf die abzutragende Schicht (11) gerichtet, der reflektierte Lichtstrahl (7) analysiert und beim Eintreten eines vorgegebenen Ergebnisses der Ätzvorgang beendet wird, **dadurch gekennzeichnet**, daß der reflektierte Lichtstrahl (7) in spektrale Komponenten zerlegt und die Intensität einer oder mehrerer Komponenten erfaßt und ausgewertet und bei einer charakteristischen Änderung des zeitlichen Kurvenverlaufs der Intensität mindestens einer spektralen Komponente der Ätzvorgang beendet wird.

2. Verfahren nach Anspruch 1, dadurch gekennzeichnet, daß die charakteristische Änderung ein Schwellpunkt, d.h. ein Hoch- bzw. Tiefpunkt in einer der Komponenten-Intensitätskurven ist.

3. Verfahren nach Anspruch 1, dadurch gekennzeichnet, daß die charakteristische Änderung ein Wendepunkt in einer der Komponenten-Intensitätskurven ist.

4. Verfahren nach Anspruche 1, dadurch gekennzeichnet, daß die charakteristische Änderung durch den Überkreuzungspunkt zweier Komponenten-Insentitätenkurven gegeben ist.

5. Verfahren nach einem der Ansprüche 1 bis 4, dadurch gekennzeichnet, daß der Ätzvorgang zu einem späteren Zeitpunkt (tₑ) abgebrochen wird als dem der charakteristischen Änderung korrespondierenden Triggerzeitpunkt (t₀).

6. Verfahren nach einem der Ansprüche 1 bis 5, dadurch gekennzeichnet, daß die Zeit zwischen Anfang und Ende des Ätzvorgangs erfaßt und beim Überschreiten einer vorgegebenen Abweichung von einem vorbestimmten Sollwert eine Fehlermeldung erfolgt.

7. Verfahren nach einem der Ansprüche 1 bis 6, dadurch gekennzeichnet, daß die abzutragende Schicht eine Metallschicht ist.

8. Vorrichtung zur Durchführung des Verfahrens nach einem der Ansprüche 1 bis 6, mit einer Weißlicht-Lampe (4), einem anschließenden Lichtleiter (6), einem weiteren Lichtleiter (7) an den sich ein handelsüblicher Wellenlängenanalysator anschließt, durch den die Wellenlänge des reflektierten Lichts mit der Wellenlänge der Weißlicht-Lampe (4) verglichen und in Abhängigkeit vom Meßergebnis der Ätzvorgang steuerbar ist, dadurch gekennzeichnet, daß durch den Wellenlängenanalysator (8) das reflektierte Licht in Spektralfarbkomponenten zerlegbar ist und die Komponentenintensitäten erfaßt und in Meßsignale transformierbar sind und daß eine mit einer Meßsignalerfassung (2) versehene Datenverarbeitungsanlage (3) vorgesehen ist zur Echtzeitauswertung der Meßsignale und Steuerung der gesamten Ätzvorrichtung.

## Claims

1. A process for monitoring and controlling an etching operation, in which one or more layers (11) which are applied to a substrate (10) and which wave-selectively reflect light are removed with a predetermined etching time (tₑ), wherein during the etching operation a light beam (6) with white light is projected on to the layer (11) to be removed, the reflected light beam (7) is analysed and the etching operation is terminated when a predetermined outcome occurs, characterised in that the reflected light beam (7) is split up into spectral components and the intensity of one or more components is detected and evaluated and the etching operation is terminated upon a characteristic change in the curve configuration in respect of time of the intensity of at least one spectral component.

2. A process according to claim 1 characterised in that the characteristic change is a threshold point, that is to say a high or low point, in one of the component intensity curves.

3. A process according to claim 1 characterised in that the characteristic change is a point of inflection in one of the component intensity curves.

4. A process according to claim 1 characterised in that the characteristic change is given by the cross-over point of two component intensity curves.

5. A process according to one of claims 1 to 4 characterised in that the etching operation is broken off at a later time (tₑ) than the trigger time (t_{O}) corresponding to the characteristic change.

6. A process according to one of claims 1 to 5 characterised in that the time between the beginning and the end of the etching operation is detected and a fault signal is effected when a predetermined departure from a predetermined reference value is exceeded.

7. A process according to one of claims 1 to 6 characterised in that the layer to be removed is a metal layer.

8. Apparatus for carrying out the process according to one of claims 1 to 6 comprising a white light lamp (4), an adjoining light guide (6), a further light guide (7) to which there is connected a commercially available wavelength analyser by which the wavelength of the reflected light is compared with the wavelength of the white light lamp (4) and the etching operation can be controlled in dependence on the measurement result, characterised in that the reflected light is split up into spectral colour components by the wavelength analyser (8) and the component intensities are detected and can be transformed into measurement signals and that there is provided a data processing installation (3) provided with a measurement signal detection means (2) for real-time evaluation of the measurement signals and control of the entire etching apparatus.

## Revendications

1. Procédé pour la surveillance et la commande d'une opération de gravure dans laquelle une ou plusieurs couches réfléchissantes (11) sélectives en longueur d'onde, déposées sur un substrat (10), sont enlevées en un temps de gravure (tₑ) prédéterminé, procédé dans lequel, pendant l'opération de gravure, un rayon lumineux (6) de lumière blanche est dirigé sur la couche (11) à enlever, le rayon lumineux réfléchi (7) est analysé et l'opération de gravure est interrompue lorsqu'on a atteint un résultat prédéterminé, caractérisé en ce que le rayon lumineux réfléchi (7) est décomposé en composantes spectrales, et l'intensité d'une ou plusieurs composantes est détectée et analysée et, en présence d'une variation caractéristique du profil de la courbe de l'intensité d'au moins une composante spectrale en fonction du temps, l'opération de gravure est interrompue.

2. Procédé selon la revendication 1, caractérisé en ce que la variation caractéristique est un seuil, c'est-à-dire un maximum ou un minimum d'une des courbes d'intensité des composantes.

3. Procédé selon la revendication 1, caractérisé en ce que la variation caractéristique est un point d'inflexion d'une des courbes d'intensité des composantes.

4. Procédé selon la revendication 1, caractérisé en ce que la variation caractéristique est donnée par le point d'intersection de deux courbes d'intensité de composante.

5. Procédé selon l'une des revendications 1 à 4, caractérisé en ce que l'opération de gravure est interrompue à un instant (tₑ) postérieur à l'instant de déclenchement (t₀) qui correspond à la variation caractéristique.

6. Procédé selon l'une des revendications 1 à 5, caractérisé en ce que le temps qui s'écoule entre le début et la fin de l'opération de gravure est mesuré, et qu'une signalisation de défaut est déclenchée lors du dépassement d'un écart prédéterminé par rapport à une valeur de consigne pré-établie.

7. Procédé selon l'une des revendications 1 à 6, caractérisé en ce que la couche à enlever est une couche métallique.

8. Dispositif pour la mise en oeuvre du procédé selon l'une des revendications 1 à 6, comprenant une lampe (4) à lumière blanche, un conducteur de lumière (6) qui y est raccordé, un autre conducteur de lumière (7), auquel se raccorde un analyseur de longueur d'onde habituel du commerce, dans lequel la longueur d'onde de la lumière réfléchie est comparée à la longueur d'onde de la lumière de la lampe (4) à lumière blanche, l'opération de gravure pouvant être commandée en fonction du résultat de la mesure, caractérisé en ce que l'analyseur de longueur d'onde peut décomposer la lumière réfléchie en composantes chromatiques du spectre et les intensités des composantes sont captées et peuvent être transformées en signaux de mesure, et en ce qu'il est prévu un ordinateur (3) muni d'un dispositif (2) de détection des signaux de mesure, et servant à l'analyse en temps réel des signaux de mesure et à la commande de l'ensemble du dispositif de gravure.
